# FASCICULE DE BREVET EUROPEEN

(11) **EP 0 312 415 B1**
(45) Date de publication et mention de la délivrance du brevet: **07.04.1993**
(21) Numéro de dépôt: 88402418.3
(22) Date de dépôt: 26.09.1988
(51) Int. Cl.: H05K 3/04, H05K 3/20

(54) **Plaque circuit pour courants élevés et procédé de préparation**
Leiterplatten für hohe Ströme und Verfahren zur Herstellung
Circuit board for high currents and process of making the same

(30) Priorité: 12.10.1987 FR 8714039
(43) Date de publication de la demande: 19.04.1989
(73) Titulaire: DAV, Société dite, F-74101 Annemasse Cédex (FR)
(72) Inventeur: Torcheux, Bertrand, F-74100 Ambilly (FR); Viennois, Jean-Paul, F-74100 Ville-La-Grand (FR)
(74) Mandataire: Levy, David

(56) Documents cités:
- DE-A- 2 536 029
- DE-B- 1 237 191
- FR-A- 2 272 573
- FR-A- 2 344 151
- FR-A- 2 345 888
- FR-A- 2 531 597

## Description

La présente invention concerne une plaque circuit pour courants élevés et, plus particulièrement, une plaque circuit réalisée dans une plaque métallique, ainsi qu'un procédé de fabrication.

Les circuits imprimés pour la réalisation de platines de servitude pour véhicule automobile ne dépassent guère 0,1 mm d'épaisseur et sont limités dans leur utilisation par les chutes de tension et par le manque de tenue aux court-circuits.

Lorsqu'on souhaite le passage de courants élevés il faut soit augmenter la largeur des circuits électriques ce qui conduirait alors à utiliser des plaques de très grandes dimensions incompatibles avec la tendance à la miniaturisation des circuits et à la place disponible sur les véhicules, soit augmenter l'épaisseur de la plaque pour éviter les dimensions prohibitives.

Pour remédier aux inconvénients dus à des dimensions et/ou à une épaisseur de plaque trop importante, on a proposé de réaliser le circuit imprimé sous la forme d'un empilage de plaques de circuits séparées les unes des autres par une feuille isolante accolée de préférence sur une plaque. Les circuits sont découpés dans des plaques métalliques et sont reliés entre eux par des pontets qui peuvent être éliminés par emboutissage, par exemple, de manière à former des circuits électriques séparés. Cela revient en fait à dissocier les fonctions qui doivent être assurées par l'ensemble desdits circuits. De toutes les façons, l'empilage doit être maintenu serré dans un boîtier et les différentes plaques reliées entre elles par des broches insérées à force dans des orifices ménagés à cet effet dans lesdites plaques. Un tel empilage est notamment décrit et représenté dans le brevet français No. 2.362.504.

Dans le document FR-A-2 531 597, il est décrit un circuit imprimé qui permet le passage de courants élevés sans être limité par la diffusion thermique due au passage du courant comme cela se produit pour les circuits empilés connus. Un tel circuit imprimé est réalisé à partir d'une plaque métallique dont une face est recouverte par un isolant, l'autre face étant découverte, et dans laquelle sont découpés des circuits électriques séparés par des passages et reliés entre eux par des pontets de liaison, ledit isolant étant interrompu au-dessus d'orifices ménagés dans la plaque pour le positionnement et la soudure de broches de connexion, l'isolant étant introduit également dans lesdits passages de manière à renforcer la tenue de ladite plaque.

Après l'opération de surmoulage, on procède ensuite à la séparation entre pistes en découpant les pontets de liaison notamment au moyen d'un poinçon de découpage qui enlève, en même temps que les pontets métalliques reliant les pistes, l'isolant qui le recouvre sur les deux faces du circuit imprimé. De ce fait, le circuit imprimé surmoulé comporte des orifices, éventuellement entourés de zones métalliques non recouvertes d'isolant, qui, n'auront ultérieurement aucune fonction et qui matérialisent seulement les emplacements des pontets de liaison.

La présente invention a pour objet une plaque circuit surmoulée haute densité qui permet une réalisation plus facile d'un circuit simple face ou double face.

Selon une caractéristique de la présente invention, la plaque circuit surmoulée est du type comprenant une feuille métallique dans laquelle sont découpées des pistes séparées constituant au moins un circuit électrique, des orifices dont certains sont ménagés pour le passage des composants à connecter auxdites pistes, une couche d'isolant disposée sur au moins une face de ladite feuille métallique, et elle est caractérisée en ce qu'au moins une partie des rattaches reliant les pistes sont coupées et repliées autour d'une de leurs extrémités vers la face recouverte d'isolant, et en ce que lesdites rattaches sont dans leur majeure partie qui est repliée, noyées dans l'isolant.

Un avantage de la présente invention réside dans le fait qu'on élimine une opération de découpe après surmoulage, celle des pontets de liaison ou rattaches qui sont conservés.

Par ailleurs, on réduit notablement la quantité d'isolant injectée entre les pistes, sur la face opposée à la face dite de soudure, l'isolant entre pistes entourant les rattaches repliées étant susceptible de constituer des zones de support pour une autre plaque circuit nue devant être associée à la précédente afin de constituer une plaque circuit double face, lorsqu'on souhaite réaliser une plaque circuit de plus haute densité et occupant le minimum de place dans un boîtier d'interconnexion. Il en résulte un plus grand nombre de fonctions susceptibles d'être assurées par ledit boîtier d'interconnexion sans nécessiter davantage de place dans le véhicule automobile, par exemple, qui doit être équipé avec un tel boîtier d'interconnexion.

D'autres avantages et caractéristiques ressortiront mieux à la lecture de la description de l'invention, donnée à titre indicatif mais non limitatif, ainsi que des dessins annexés sur lesquels :
La figure 1 est une vue de dessus d'une feuille métallique non recouverte d'isolant et avant découpe et pliage des rattaches de liaison.
La figure 2 est une vue de dessus de la face dite de soudure de la feuille métallique recouverte d'isolant et constituant une première plaque circuit.
La figure 3 est une vue de dessous de la plaque circuit représentée sur la figure 2.
La figure 4 est une vue en coupe partielle de la plaque circuit, au niveau d'une rattache de liaison.
La figure 5 est une vue de dessus de la figure 4.
La figure 6 est une vue en coupe suivant VI-VI de la figure 4.
La figure 7 est une vue de dessus schématique d'une liaison entre plusieurs pistes.
La figure 8 est une vue de dessus d'une rattache de liaison repliée et surmoulée suivant une autre forme de réalisation de la présente invention.
La figure 9 est une vue de dessus d'une deuxième plaque circuit , non recouverte d'isolant, et devant être associée à la première plaque circuit des figures 1 à 7 pour constituer une plaque circuit double face.
La figure 10 est une vue en coupe d'une plaque circuit double face avec un circuit imprimé associé.
La figure 11 est une vue en coupe schématique d'un boîtier d'interconnexion dans lequel sont montées les plaques circuit des figures 1 à 10.
La figure 12 est une vue de dessus d'une plaque circuit de base représentée schématiquement sur la figure 11.

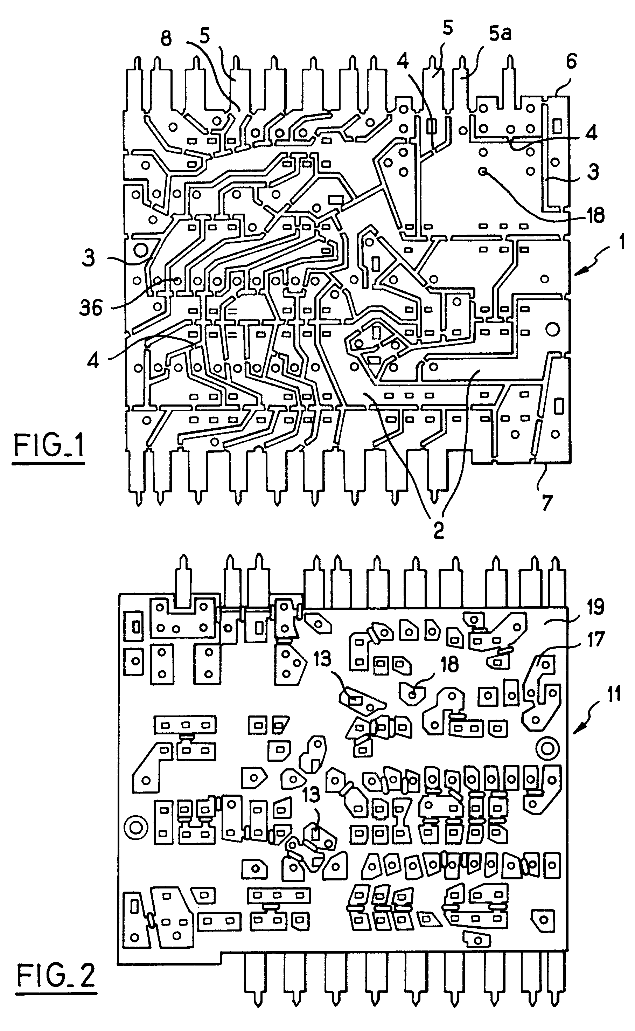

La plaque circuit selon la présente invention est réalisée à partir d'une feuille ou plaque métallique 1, d'épaisseur appropriée, et dans laquelle sont découpés des circuits électriques ou pistes 2 délimitant entre eux des passages 3, (figure 1). Le découpage des pistes 2 dans la plaque 1 est, de préférence, effectué mécaniquement, lesdites pistes étant reliées entre elles par des rattaches de liaison 4.

Lors du découpage des pistes 2, des languettes de liaison 5 sont également découpées sur au moins un des côtés latéraux de la plaque 1, et de préférence, sur deux côtés opposés 6 et 7. Les languettes de liaison 5 servent, après pliage à 90° autour de leur extrémité 8, à relier ladite plaque circuit à un support tel qu'une embase ou à un autre ensemble électrique tel qu'un circuit imprimé. Les languettes de liaison 5 peuvent présenter entre elles des dimensions différentes qui sont adaptées aux logements susceptibles de les recevoir. Sur la figure 1, on a représenté des languettes de liaison 5 et 5a présentant des largeurs différentes. De même, les intervalles séparant deux languettes adjacentes peuvent varier en fonction du positionnement desdits logements correspondants.

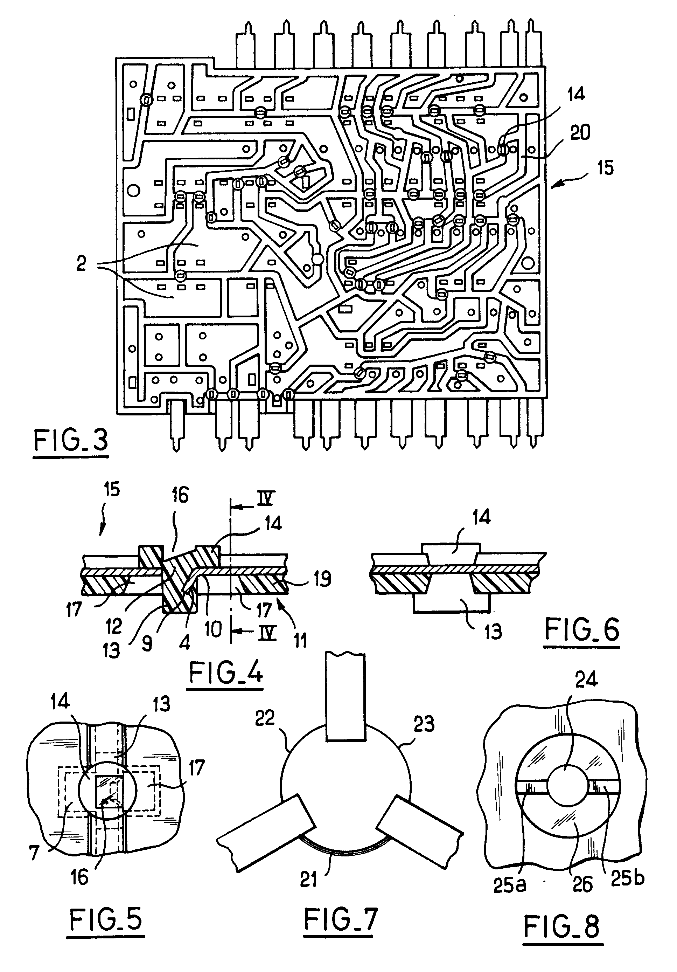

Les rattaches 4 sont coupées à l'une de leurs extrémités 9 et repliées autour de leur autre extrémité 10 suivant un angle qui dépend des formes des poinçons et contre-poinçons de découpage utilisés, non représentés pour ne pas surcharger inutilement les dessins, ledit angle pouvant varier entre de larges limites (figure 4). De préférence, les rattaches 4 sont pliées vers la face de soudure 11 de la plaque circuit. Le surmoulage de la plaque 1 est effectué par injection d'isolant sur la face de soudure 11.

L'isolant injecté s'écoule autour du poinçon de découpage dans l'espace 12 crée par la découpe et le pliage de chaque rattache 4, de manière à noyer au moins partiellement ladite partie de rattache repliée. De préférence, la partie de rattache repliée est totalement noyée dans l'isolant par relevage partiel du poinçon de découpage (figure 4). Le surmoulage de chaque rattache 4 ainsi réalisé permet d'obtenir des éléments en relief 13, 14, dont la forme et la hauteur dépendent de la forme et de la profondeur du contre-poinçon utilisé avec le poinçon de découpage. L'élément en relief 13 du côté de la face de soudure 11 se présente de préférence sous la forme d'une barrette parallélépipédique, mais pourrait être de n'importe quelle autre forme souhaitée. De même, l'orientation d'une barrette à l'autre peut être différente. Les barrettes peuvent être entre elles perpendiculaires, parallèles ou de tout autre relation angulaire, comme cela est représenté sur la figure 2. L'élément en relief 14, du côté de la face 15 représentée sur la figure 4, se présente sous la forme d'un pion cylindrique avec une empreinte 16, ce qui correspond à la forme du poinçon de découpage utilisé. De part et d'autre de chaque barrette surmoulée 13, il existe une zone métallique 17 non recouverte d'isolant qui peut éventuellement être utilisée pour une liaison d'un composant avec la plaque circuit, par une technique bien connue dite de soudure à l'étain, telle qu'une soudure à la vague.

La plaque circuit ainsi surmoulée présente une face de soudure 11 recouverte d'isolant 19 (figure 2), avec des zones 17 dépourvues d'isolant, avec des orifices 18 pour la liaison des composants des barrettes surmoulées 13 présentant différentes orientations, et une face opposée 15 (figure 3), sur laquelle les pistes 2 sont isolées les unes des autres par de l'isolant 20 remplissant les passages 3. Aux endroits correspondants aux rattaches 4 se trouvent les pions 14 avec leur empreinte 16.

De préférence, la hauteur en épaisseur des barrettes 13 est supérieure à l'épaisseur de la couche 19 d'isolant, tandis que la hauteur des pions 14 est sensiblement égale à l'épaisseur d'isolant 20 introduit dans les passages 3 de manière à réaliser une surface d'appui régulière pour éventuellement une autre plaque circuit.

La plaque circuit surmoulée représentée sur les figures 1 à 6, constitue une première plaque circuit dont les rattaches 4 sont noyées dans des barrettes rectangulaires. Il peut arriver qu'on soit dans une configuration entre pistes de forme polygonale comme cela est représenté sur la figure 7.

Dans ce cas, on est en présence d'une rattache en trois parties 21, 22, 23, en forme d'arc de cercle dont deux parties 22 et 23 sont coupées tandis que la partie 21 est repliée comme pour les rattaches 4.

Suivant une autre forme de réalisation suivant l'invention, l'élément en relief du côté de la face de soudure 11 peut présenter la structure représentée sur la figure 8. L'élément en relief comprend une cheminée centrale 24 dans laquelle est noyée la partie de rattache repliée, ladite cheminée centrale étant reliée au reste de l'isolant par un bourrelet d'isolement en deux parties 25a et 25b, qui peuvent être dans le prolongement l'une de l'autre, comme représenté, ou faisant un angle quelconque entre elles. Le bourrelet d'isolement 25a-25b entre pistes permet d'éviter des pontages d'étain lorsque ce dernier est utilisé comme métal de soudure. De part et d'autre du bourrelet d'isolement et de la cheminée centrale 24 sont ainsi ménagées des zones 26 où le métal de la plaque 1 est à nu. Bien entendu, la forme particulière de la cheminée centrale et du bourrelet d'isolement est obtenue par des contre-poinçons appropriés.

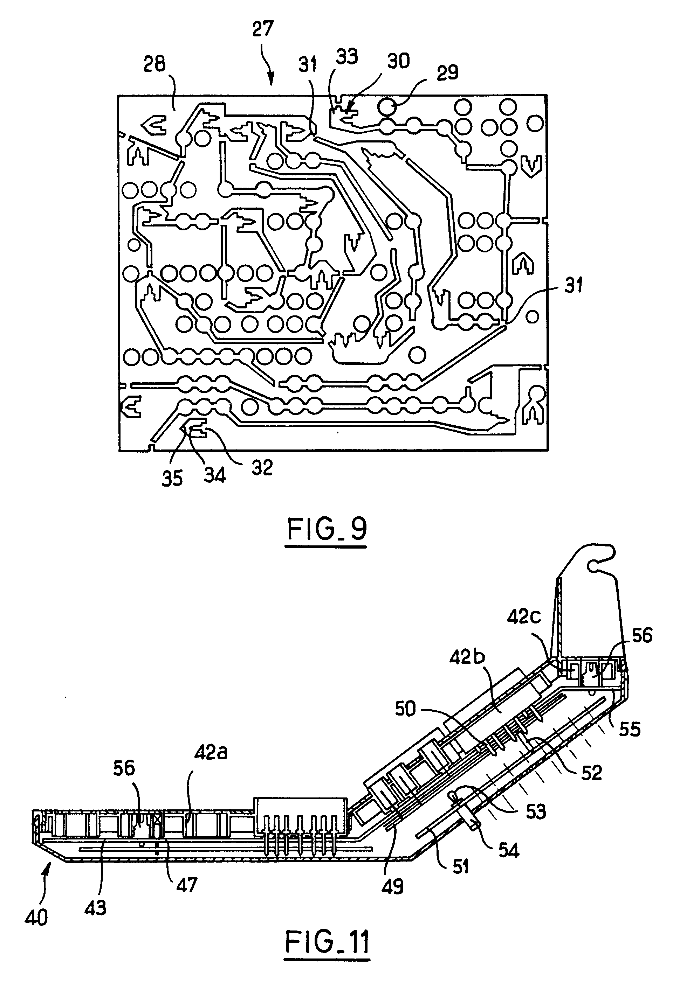

Une deuxième plaque circuit est représentée sur la figure 9 et elle est conçue pour être associée à la première plaque circuit surmoulée afin de constituer un circuit double face qui permet d'augmenter considérablement la densité du circuit ainsi constitué tout en occupant un minimum de place.

La deuxième plaque circuit est, comme la première plaque circuit, obtenue à partir d'une plaque métallique 27 dans laquelle sont découpées d'une part des pistes 28, les différents orifices 29 de positionnement et/ou de passages pour les composants à connecter, et, d'autre part, des organes de liaison 30. Les rattaches 31 entre les pistes 28 sont entièrement découpées et enlevées lors d'une phase ultérieure.

Les organes de liaison 30 sont, par exemple, en forme de pointe et sont repliés autour de leur extrémité élargie 32. Un espace 33 est ménagé entre les pointes 34 et le bord 35, également en forme de pointe, de manière à permettre un pliage à 90° de ladite pointe 34.

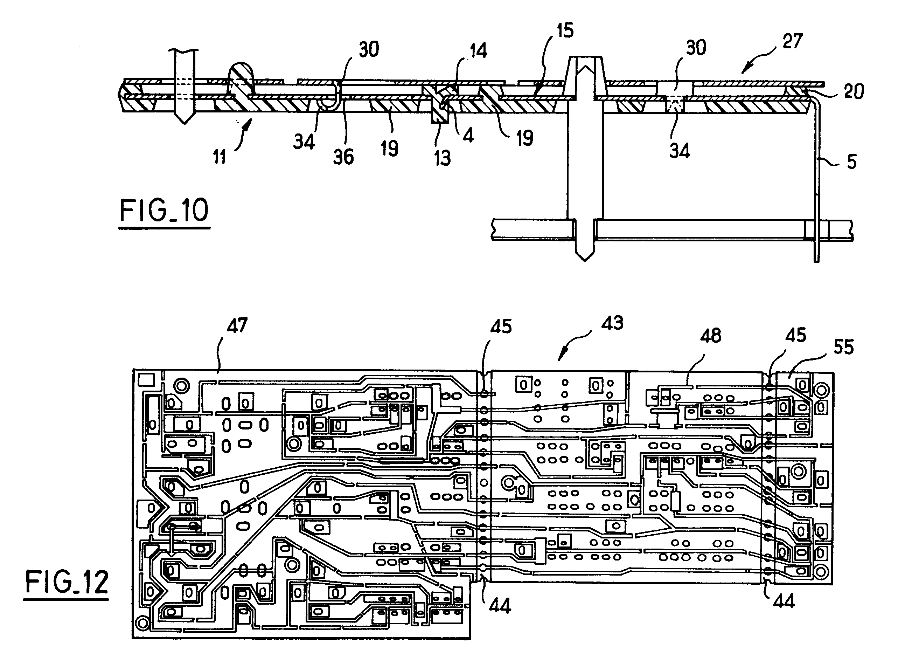

Le circuit double face (figure 10) est obtenu en disposant la plaque découpée 27 sur la face 15 du premier circuit en appui sur l'isolant 20 et les pions 14, en repliant les organes de liaison 30 de manière à introduire les pointes 34 dans des orifices appropriés 36 ménagés sur la plaque 1, et en rabattant lesdites pointes 34 sur la partie métallique située autour desdits orifices 36 de façon à réaliser une liaison mécanique et électrique après soudure entre les pistes des deux plaques circuits.

En se référant aux figures 5, 6 et 9 on peut constater que les deux plaques circuits constituant le circuit double face tel qu'il vient d'être décrit, sont sensiblement de mêmes dimensions. Il va de soi qu'il peut en être autrement.

Sur la figure 10 est représentée une coupe partielle d'un circuit double face. La première plaque circuit surmoulée réunie à la deuxième plaque circuit par les organes de liaison 30 dont les pointes 34 sont pincées sur une partie dépourvue d'isolant de la première plaque circuit afin d'assurer, après soudure, la liaison électrique entre les deux circuits.

Les plaque circuits simple et/ou double face sont généralement utilisées dans des boîtiers de connexion qui assurent diverses fonctions, dont celle d'assurer l'alimentation en courant électrique de certains accessoires d'un véhicule automobile. En raison du fait que les types de courant peuvent être faibles ou élevés, il était nécessaire de réaliser un boîtier de connexion ou appelé encore boîtier d'interconnexion capable de recevoir un empilage de plaques circuits et de circuits imprimés dans un encombrement réduit, avec des chutes de tension minimales dans les liaisons électriques, et qui puisse être réalisé à partir de moyens de production de grande série pour un prix de revient avantageux.

Un tel boîtier d'interconnexion est représenté sur la figure 11 et il est désigné dans son ensemble par la référence 40.

Le boîtier 40 comprend un fond qui est associé à trois embases 42a à 42c. Les embases 42a à 42c sont de préférence réalisées par moulage et sont rattachées entre elles par des parties de liaison qui ne sont pas représentées sur la figure 11 car elles sont coupées, après montage desdites embases. Les embases font entre elles un angle compris entre 0 et 180° et de préférence un angle compris entre 90 et 180° pour deux embases adjacentes, et servent à maintenir et positionner les composants de connectique tels que réceptacles et languettes devant être reliés à des organes externes tels que relais ou fusibles. Une plaque circuit surmoulée face 43 analogue à la première plaque circuit, mais de grandes dimensions, est montée sur les embases et constitue une plaque circuit de base. De manière à pouvoir être plié en fonction de la configuration finale du boîtier 40, le circuit 43 comprend une ou plusieurs zones 44 qui sont dépourvues d'isolant sur les deux faces. De plus, des orifices 45 sont également ménagés dans lesdites zones 44 afin de faciliter le pliage homogène du circuit 43 (figure 12). Le boîtier 40 peut également comprendre un autre circuit surmoulé également semblable au premier circuit, les deux circuits étant reliés entre eux par les extrémités des composants des connectiques. L'autre circuit est, dans l'exemple représenté sur la figure 11, associé à la partie gauche 47 du circuit 43 (figure 12). A la partie intermédiaire 48 du circuit 43, adjacente à la partie 47, est associé un circuit double face désigné dans son ensemble par la référence 49 et constitué par les premier 1 et deuxième circuits 27 tels que décrits ci-dessus. Le circuit double face 49 et la partie 48 du circuit 43 sont reliés entre eux par des extrémités des composants de connectique 50 tandis que la liaison entre ledit circuit double face 49 et un autre circuit 51 est assurée par une ou plusieurs languettes 52. Le circuit 51 comprend des réceptacles 53 dont un seul est représenté sur la figure 11, et aptes à recevoir des fusibles 54.

La partie terminale 55 du circuit 43 est pliée à l'horizontale par rapport à la partie intermédiaire 48 et elle est associée à l'embase 42c.

Les trois embases 42a à 42c sont accessibles de l'extérieur, du côté opposé à celui sur lequel est monté le circuit 43. Chacune des trois embases comprennent les réceptacles appropriés à l'introduction et/ou liaison des divers composants électroniques et/ou électriques qui doivent être connectés au boîtier d'interconnexion 40. C'est ainsi que par exemple on a représenté deux réceptacles 56 pour relais, l'un sur l'embase 42a et l'autre sur l'embase 42c.

Enfin, un couvercle, muni d'orifices appropriés pour le passage des composants électroniques, est monté sur les embases 42a à 42c. Enfin, des moyens de montage tels qu'une patte de montage 58 peuvent être prévus sur le couvercle.

## Revendications

1. Plaque circuit surmoulée, du type comprenant une feuille métallique (1) dans laquelle sont découpées des pistes (2) séparées constituant au moins un circuit électrique, des orifices (18) dont certains sont ménagés pour le passage des composants à connecter auxdites pistes, une couche d'isolant (19) disposée sur au moins une face de ladite feuille métallique caractérisée en ce qu'au moins une partie des rattaches (4) reliant les pistes (2) sont coupées et repliées autour d'une de leurs extrémités vers la face (11) recouverte d'isolant (19), et en ce que lesdites rattaches sont dans leur majeure partie qui est repliée, noyées dans de l'isolant.

2. Plaque circuit selon la revendication 1, caractérisée en ce que l'isolant (13) comprenant la partie repliée des rattaches présente une épaisseur supérieure à la longueur de la partie de rattache repliée et constitue un élément en relief présentant une épaisseur plus grande que celle de la couche d'isolant (19).

3. Plaque circuit selon la revendication 1, caractérisée en ce que les pistes, sur la face opposée à celle recouverte d'isolant, sont isolées les unes par rapport aux autres par de l'isolant, et en ce que les parties d'isolant (14), au niveau des rattaches, présentent une épaisseur sensiblement égale à celle de l'isolant entre pistes.

4. Plaque circuit selon la revendication 1, caractérisée en ce que des languettes de liaison (5) sont ménagées sur au moins un des côtés dudit circuit.

5. Plaque circuit selon les revendications 1 et 4, caractérisée en ce qu'une autre feuille métallique (27) nue et préalablement découpée est montée sur ladite plaque circuit surmoulée de manière à constituer un circuit double face, en ce que ladite feuille métallique nue qui constitue une deuxième plaque circuit comprend des organes de liaison (30) prévus entre les pistes, ladite deuxième plaque circuit étant disposée sur la face opposée du premier circuit qui est recouverte d'isolant, et en ce que les organes de liaison (30) passent à travers des orifices (36) appropriés du premier circuit surmoulé et sont repliés pour être accrochés par une extrémité sur ledit premier circuit surmoulé.

6. Plaque circuit selon la revendication 5, caractérisée en ce que les organes de liaison (30) sont accrochés par leur extrémité libre (34) sur une zone des pistes du premier circuit surmoulé dépourvue d'isolant, de manière à relier électriquement au moins une piste de la première plaque circuit surmoulée à au moins une piste de la deuxième plaque circuit.

7. Plaque circuit selon l'une des revendications 5 ou 6, caractérisée en ce que les organes de liaison (30) présentent une extrémité libre (34) sensiblement en forme de pointe.

8. Plaque circuit selon l'une des revendications 1 ou 5, caractérisée en ce que l'élément en relief d'isolant est constitué par une barrette (13) de forme parallélépipédique.

9. Plaque circuit selon la revendication 8, caractérisée en ce que les barrettes (13) sont orientées différemment les unes par rapport aux autres.

10. Plaque circuit selon l'une des revendications 1 ou 5, caractérisée en ce que l'élément en relief d'isolant (14) est constitué par un pion vertical (24) de hauteur supérieure à l'épaisseur de la couche d'isolant, ledit pion (24) étant disposé au centre d'une zone dépourvue d'isolant et relié à la couche d'isolant par deux pontets d'isolant (25a, 25b).

11. Plaque circuit selon la revendication 10, caractérisée en ce que les pontets (25a, 25b) situés de chaque côté d'un même pion sont alignés.

12. Plaque circuit selon la revendication 11, caractérisée en ce que les directions des alignements des pontets sont différentes.

13. Procédé de fabrication d'une plaque circuit selon la revendication 1, selon lequel on découpe, dans une feuille métallique (1), des pistes (2) constituant au moins un circuit électrique et reliées entre elles par des rattaches (4), on forme des orifices (18) notamment pour le passage de composants à connecter auxdites pistes sur une face dudit circuit imprimé, on recouvre ladite face du circuit par un isolant (19), au moyen d'une technique dite de surmoulage, et qui est caractérisé en ce qu'au moins une partie des rattaches est sectionnée à une de leurs extrémités et pliée autour de leur autre extrémité préalablement au surmoulage, de façon que l'isolant passe dans l'espace crée par le pliage des rattaches et recouvre dans leur majeure partie les rattaches pliées.

14. Procédé selon la revendication 13, caractérisé en ce que les rattaches sont sectionnées et pliées lors d'une même opération.

15. Procédé selon la revendication 13, caractérisé en ce qu'on découpe, en même temps que les pistes, des languettes de liaison qui sont disposées sur au moins un côté de la feuille métallique.

16. Plaque circuit selon l'une des revendications 1 ou 5, caractérisée en ce qu'elle comprend sur chacune de ses faces au moins une zone continue (44), dépourvue totalement d'isolant, et munie d'orifices (45) alignés de manière à permettre le pliage de ladite plaque le long desdits orifices.

17. Boîtier d'interconnexion obtenu au moyen des plaques circuits selon l'une des revendications 1 à 12 et 16, du type comprenant une embase moulée (42a, 42b, 42c) en matière plastique sur laquelle des organes de connexion sont accessibles sur les deux faces opposées de ladite embase, et caractérisé en ce qu'au moins un pre-premier circuit simple face est monté sur ladite embase qui est constituée en plusieurs parties qui forment entre elles un angle compris entre zéro et 180°, et en ce qu'au moins un deuxième circuit double face (49) est monté sur une partie du premier circuit, et en ce qu'au moins un troisième circuit imprimé (51) est connecté au circuit double face, ledit troisième circuit imprimé comportant des réceptacles (53) pour des composants .

18. Boîtier selon la revendication 17, caractérisé en ce que ladite embase est constituée en trois parties, la première (42a) disposée horizontalement et faisant un angle compris entre 90° et 180° avec la deuxième partie adjacente (42b), les première (42a) et troisième (42c) parties étant sensiblement parallèles mais dans des plans différents.

19. Boîtier selon la revendication 18, caractérisé en ce que les trois parties de l'embase sont distinctes et reliées entre elles par l'intermédiaire du premier circuit.

20. Boîtier selon les revendications 17 à 19, caractérisé en ce que l'embase et les circuits qui lui sont reliés sont montés dans l'espace délimité par un fond (41) et un couvercle (57) qui présentent sensiblement la forme de ladite embase.

21. Boîtier selon la revendication 20, caractérisé en ce que le fond et le couvercle sont munis de moyens (56) aptes à permettre de l'extérieur l'enfichage et la liaison électrique des composants à connecter auxdits circuits imprimés solidaires de l'embase.

## Claims

1. Moulded circuit board, of the type comprising a metal sheet (1) into which separate tracks (2) are cut constituting at least one electrical circuit, orifices (18), some of which are provided for the components to be connected to the said tracks to pass through, a layer of insulating material (19) disposed on at least one face of the said metal sheet, characterised in that at least some of the fasteners (4) connecting the tracks (2) are cut and bent about one of their ends towards the face (11) covered with insulating material (19) and in that the said attachments are, in their major part, which is bent, embedded in the insulating material.

2. Circuit board according to Claim 1, characterised in that the insulating material (13) comprising the bent part of the attachments has a thickness greater than the length of the bent attachment part and constitutes a raised relief component having a thickness greater than that of the layer of insulating material (19).

3. Circuit board according to Claim 1, characterised in that the tracks on the face opposite to the one covered with insulating material are insulated from each other by insulating material, and in that the portions of insulating material (14), at the attachments, have a thickness substantially equal to that of the insulating material between tracks.

4. Circuit board according to Claim 1, characterised in that connecting blades (5) are provided on at least one of the edges of the said circuit.

5. Circuit board according to Claims 1 and 4, characterised in that another metal sheet (27), which is bare and has previously been cut, is mounted on the said moulded circuit board so as to constitute a double-face circuit, in that the said bare metal sheet which constitutes a second circuit board comprises connecting devices (30) provided between the tracks, the said second circuit board being disposed on the opposite face of the first circuit which is covered with insulating material, and in that the connecting devices (30) pass through suitable orifices (36) in the first moulded circuit and are bent so as to be hooked by one end onto the said first moulded circuit.

6. Circuit board according to Claim 5, characterised in that the connecting devices (30) are hooked by their free end (34) onto an area of the tracks on the first moulded circuit which has no insulating material, so as to connect electrically at least one track on the first moulded circuit board to at least one track on the second circuit board.

7. Circuit board according to one of Claims 5 or 6, characterised in that the connecting devices (30) have a free end (34) substantially in the form of a spike.

8. Circuit board according to one of Claims 1 or 5, characterised in that the raised relief insulating component consists of a bar (13) with a parallelepipedal shape.

9. Circuit board according to Claim 8, characterised in that the bars (13) are oriented differently from each other.

10. Circuit board according to one of Claims 1 or 5, characterised in that the raised relief insulating component (14) consists of a vertical pin (24) with a height greater than the thickness of the layer of insulating material, the said pin (24) being disposed at the centre of an area which has no insulating material and connected to the layer of insulating material by two insulating bridges (25a, 25b).

11. Circuit board according to Claim 10, characterised in that the bridges (25a, 25b) situated on each side of any one pin are in line with each other.

12. Circuit board according to Claim 11, characterised in that the directions of the alignments of the bridges are different.

13. Method of manufacturing a circuit board according to Claim 1, according to which tracks (2) constituting at least one electrical circuit and connected to each other by attachments (4) are cut into a metal sheet (1), orifices (18) are formed on one face of the said printed circuit, notably for components to be connected to the said tracks to pass through, the said face of the circuit is covered with an insulating material (19) by means of a so-called moulding technique, and which is characterised in that at least some of the attachments are cut at one end and bent about their other end prior to the moulding, so that the insulating material passes into the space created by the bending of the attachments and covers the major part of the bent attachments.

14. Method according to Claim 13, characterised in that the attachments are cut and bent in a single operation.

15. Method according to Claim 13, characterised in that connecting blades, which are disposed on at least one edge of the metal sheet, are cut out at the same time as the tracks.

16. Circuit board according to one of Claims 1 or 5, characterised in that it comprises, on each of its faces, at least one continuous area (44) which is completely without insulating material and is provided with orifices (45) aligned so as to allow the bending of the said plate along the said orifices.

17. Interconnection box obtained by means of the circuit board according to one of Claims 1 to 12 and 16, of the type comprising a moulded mount (42a, 42b, 42c) made from plastics material on which the connecting devices are accessible on the two opposite faces of the said mount, and characterised in that at least one first single-face circuit is mounted on the said mount, which is formed in several parts forming between them an angle of between zero and 180°, and in that at least a second double-face circuit (49) is mounted on a part of the first circuit, and in that at least a third printed circuit (51) is connected to the double-face circuit, the said third printed circuit having receptacles (53) for components.

18. Box according to Claim 17, characterised in that the said mount is formed in three parts, the first (42a) disposed horizontally and forming an angle of between 90° and 180° to the adjacent second part (42b), the first (42a) and third (42c) parts being substantially parallel but in different planes.

19. Box according to Claim 18, characterised in that the three parts of the mount are separate and connected to each other by means of the first circuit.

20. Box according to Claims 17 to 19, characterised in that the base and the circuits which are connected to each other are mounted in the space defined by a bottom (41) and cover (57) which are substantially in the shape of the said mount.

21. Box according to Claim 20, characterised in that the bottom and cover and provided with means (56) suitable for allowing, from the outside, the plugging in and electrical connection of the components to be connected to the said printed circuits fixed to the mount.

## Patentansprüche

1. Gegossene Leiterplatte des Typs, der eine Metallfolie (1) enthält, in welche getrennte, mindestens einen elektrischen Schaltkreis bildende Leiterbahnen (2) geschnitten sind, mit Löchern (18), von denen bestimmte für den Durchtritt der an die genannten Leiterbahnen anzuschließenden Bauelemente vorgesehen sind, mit einer Isoliermeterialschicht (19), die auf mindestens einer Seite der genannten Metallfolie angebracht ist, dadurch gekennzeichnet, daß mindestens ein Teil der die Leiterbahnen (2) verbindenden Stege (4) aufgeschnitten und um ihr eines Ende in Richtung auf die mit Isoliermaterial (19) beschichtete Seite (11) umgebogen sind, und dadurch, daß die genannten Stege mit ihrem größeren, umgebogenen Teil in Isoliermaterial eingebettet sind.

2. Leiterplatte nach Anspruch 1, dadurch gekennzeichnet, daß das Isoliermaterial (13), das den umgebogenen Teil der Stege umfaßt, eine Dicke hat, die größer ist als die Länge des umgebogenen Stegteils und ein reliefartig vorspringendes Element bildet, dessen Dicke größer ist als die der Isoliermaterialschicht (19).

3. Leiterplatte nach Anspruch 1, dadurch gekennzeichnet, daß die Leiterbahnen, die sich auf der von der mit Isoliermaterial bedeckten Seite abgewandten Seite befinden, voneinander durch Isoliermaterial isoliert sind, und dadurch, daß die Isoliermaterialteile (14) im Bereich der Stege im wesentlichen ebenso hoch sind wie das Isoliermaterial zwischen den Leiterbahnen.

4. Leiterplatte nach Anspruch 1, dadurch gekennzeichnet, daß die Anschlußfahnen (5) an mindestens einer der Kanten das genannten Schaltkreises angebracht sind.

5. Leiterplatte nach den Ansprüchen 1 und 4, dadurch gekennzeichnet, daß eine weitere, blanke und zuvor zugeschnittene Metallfolie (27) auf der genannten gegossenen Leiterplatte in der Weise angeordnet ist, daß ein doppelseitiger Schaltkreis gebildet wird, dadurch, daß die genannte blanke, eine zweite Leiterplatte bildende Metallfolie zwischen den Leiterbahnen vorgesehene Verbindungsorgane (30) aufweist, wobei die genannte zweite Leiterplatte auf der Seite des ersten Schaltkreises angebracht ist, die der mit Isoliermaterial beschichteten Seite entgegengesetzt ist, und dadurch, daß die Verbindungsorgane (30) durch geeignete Öffnungen (36) der ersten gegossenen Schaltung verlaufen und umgebogen sind, um sie mit einem Ende an dem genannten ersten gegossenen Scheltkreis zu befestigen.

6. Leiterplatte nach Anspruch 5, dadurch gekennzeichnet, daß die Verbindungsorgane (30) mit ihrem freien Ende (34) an einer nicht mit Isoliermaterial versehenen Zone der Leiterbahnen der ersten gegossenen Schaltung befestigt sind, so daß mindestens eine Leiterbahn der gegossenen ersten Leiterplatte mit mindestens einer Leiterbahn der zweiten Leiterplatte elektrisch leitend verbunden ist.

7. Leiterplatte nach Anspruch 5 oder 6, dadurch gekennzeichnet, daß die Verbindungsorgane (30) ein freies Ende (34) besitzen, das im wesentlichen die Form einer Spitze hat.

8. Leiterplatte nach Anspruch 1 oder 5, dadurch gekennzeichnet, daß das reliefartige Isoliermaterialelement als Stollen (13) in Form eines Parallelepipeds ausgebildet ist.

9. Leiterplatte nach Anspruch 8, dadurch gekennzeichnet, daß die Stollen (13) in voneinander verschiedenen Richtungen verlaufen.

10. Leiterplatte nach Anspruch 1 oder 5, dadurch gekennzeichnet, daß das reliefartige Isoliermaterialelement (14) als vertikales Klötzchen (24) mit einer Höhe ausgebildet ist, die größer ist als die Dicke der Isoliermaterialschicht, und daß das genannte Klötzchen (24) in der Mitte einer kein Isoliermaterial aufweisenden Zone angeordnet ist und mit der Isoliermaterialschicht durch zwei Bügel (25a, 25b) aus Isoliermaterial verbunden ist.

11. Leiterplatte nach Anspruch 10, dadurch gekennzeichnet, daß die beiden, an jeweils einer Seite ein und desselben Klötzchens angeordneten Bügel (25a, 25b) miteinander fluchten.

12. Leiterplatte nach Anspruch 11, dadurch gekennzeichnet, daß die die Bügel unterschiedlich ausgerichtet sind.

13. Verfahren zur Herstellung einer Leiterplatte gemäß Anspruch 1, wonach in eine Metallfolie (1) Leiterbahnen (2) geschnitten werden, die mindestens einen elektrischen Schaltkreis bilden und untereinander durch Stege (4) verbunden sind, ferner Löcher (18) hergestellt werden insbesondere für den Durchtritt von an die genannten Leiterbahnen auf einer Seite der genannten gedruckten Schaltung anzuschließende Bauelemente, und schließlich die genannte Seite der Schaltung nach einer als Übergießen bezeichneten Methode mit einem Isoliermaterial (19) beschichtet wird, und das dadurch gekennzeichnet ist, daß mindestens ein Abschnitt der Stege an seinem einen Ende aufgeschnitten und vor dem Übergießen um sein anderes Ende umgebogen wird, so daß das Isoliermittel in den durch das Umbiegen entstandenen Zwischenraum gelangt und jeweils einen größeren Abschnitt des umgebogenen Stegs bedeckt.

14. Verfahren nach Anspruch 13, dadurch gekennzeichnet, daß die Stege in einem einzigen Arbeitsgang aufgeschnitten und umgebogen werden.

15. Verfahren nach Anspruch 13, dadurch gekennzeichnet, daß gleichzeitig mit den Leiterbahnen Anschlußfahnen geschnitten werden, die an mindestens einer Seitenkante der Metallfolie angeordnet sind.

16. Leiterplatte nach Anspruch 1 oder 5, dadurch gekennzeichnet, daß sie auf ihren beiden Seiten jeweils mindestens einen zusammenhängenden Bereich (44) aufweist, der völlig frei von Isoliermaterial und mit in einer geraden Linie angeordneten Löchern (45) versehen ist, so daß die genannte Platte längs dieser Löcher umgebogen werden kann.

17. Verbindungskasten, hergestellt mit Hilfe von Leiterplatten nach einem der Ansprüche 1 bis 12 und 16, mit einem gespritzten Unterteil (42a, 42b, 42c) aus Kunststoff, auf welchem Unterteil Anschlußorgane auf den beiden entgegengesetzten Seiten des genannten Unterteils zugänglich sind, und dadurch gekennzeichnet, daß mindestens ein erster einseitiger Schaltkreis auf dem genannten Unterteil angeordnet ist, das aus mehreren Abschnitten besteht, die miteinander einen zwischen 0° und 180° liegenden Winkel einschließen, und dadurch, daß mindestens ein zweiter doppelseitiger Schaltkreis (49) auf einem Teil des ersten Schaltkreises angeordnet ist, und dadurch, daß mindestens eine dritte gedruckte Schaltung (51) an den doppelseitigen Schaltkreis angeschlossen ist, welche dritte gedruckte Schaltung Steckbuchsen (53) für Bauelemente aufweist.

18. Kasten nach Anspruch 17, dadurch gekennzeichnet, daß das genannte Unterteil aus drei Abschnitten besteht, von denen dar erste (42a) waagerecht angeordnet ist und einen zwischen 90° und 180° liegenden Winkel mit dem anstoßenden zweiten Abschnitt (42b) einschließt, während der erste Abschnitt (42a) und der dritte Abschnitt (42c) im wesentlichen parallel zueinander, aber in unterschiedlichen Ebenen liegen.

19. Kasten nach Anspruch 18, dadurch gekennzeichnet, daß die drei Abschnitte des Unterteils voneinander unabhängig sind und miteinander durch den ersten Schaltkreis verbunden sind.

20. Kasten nach den Ansprüchen 17 bis 19, dadurch gekennzeichnet, daß das Unterteil und die mit ihm verbundenen Schaltkreise in dem Raum angeordnet sind, der durch einen Boden und einen Deckel begrenzt ist, die zusammen im wesentlichen die Form des genannten Unterteils darstellen.

21. Kasten nach Anspruch 20, dadurch gekennzeichnet, daß der Boden und der Deckel mit Mitteln (56) versehen sind, die es erlauben, von außen das Einstecken und das elektrische Anschließen der an die genannten, mit dem Unterteil fest verbundenen gedruckten Schaltungen anzuschließenden Bauelemente vorzunehmen.
